# EUROPEAN PATENT APPLICATION

(11) **EP 1 168 904 A1**
(43) Date of publication of application: **02.01.2002**
(21) Application number: 00650061.5
(22) Date of filing: 31.05.2000
(51) Int. Cl.: H05K 7/14

(54) **A switching system**

(71) Applicant: PX Research & Development Limited, Bray, County Wicklow (IE)
(72) Inventor: Kelly, Darach, Dublin 18 (IE)
(74) Representative: Weldon, Michael James

(57) **Abstract**

A switching system (1) connects with a host computer (6) via a GPIB bus (5). A controller (3) in a chassis (2) slot transmits control signals to up to twelve switch modules (4). A passive backplane (20) is used to address the modules (4) according to voltage levels sensed on pins (A15-A18) in the connectors. The controller (3) uses the backplane to provide a 16-bit data bus (21), a module address bus (22), a register address bus (23), a control bus (24), an auxiliary bus (24) and a power supply bus (25).

## Description

The invention relates to a switching system for signal routing between instruments in testing and/or data acquisition environments, and comprising a chassis housing a power supply unit, a control module, and switch modules inserted in racks of the chassis.

Such a system is described in PCT Patent Specification No. 90/08327 (Thomson-CSF). This system interfaces between a hyperfrequency integrated circuit and the probes of an analyser and is arranged in a modular manner.

While this system is apparently quite effective for the above application, there is still a need for a switching system which allows dynamic reconfiguration of resources and a large frequency range, from DC and high voltage LF to 1000 MHz RF and Lightwave. These requirements are particularly important for many automated test and data acquisition applications

According to the invention there is provided a switching system comprising a chassis, a controller, and a plurality of switch modules inserted in racks of the chassis, characterised in that,
the system comprises a passive backplane comprising a push-fit connector for connection of each switch module to the controller, means in the controller for using passive lines of the backplane as an address bus for addressing switch modules, and for using passive lines of the backplane as a control bus for transmitting control signals to switch modules, and for using passive lines of the backplane as a data bus for communication of data with switch modules, and
the controller comprises a computer interface for interfacing of the system with a host system.

In one embodiment, the backplane comprises means for individually applying in a permanent manner a voltage to each pin of a set of pins in each switch module connector, each switch module comprises means for detecting said voltage levels and converting them to a unique address associated with the slot in which the switch module is currently inserted, and the controller comprises means for addressing switch modules on the address bus using said addresses.

In one embodiment, a voltage is applied to each of a set of four pins in each switch module connector.

In one embodiment, the voltage is either floating or ground, and each switch module comprises means for associating one bit level to floating and another bit level to ground.

In another embodiment, each switch module comprises means for informing the control module of its switch resources, correlated to the current address.

In one embodiment, the controller comprises means for placing a module identification flag on the control bus together with a switch module address on the address bus to poll return of status data identifying the switch module and its revision.

In one embodiment, each switch module comprises means for asserting a controller interrupt request on the control bus.

In one embodiment, the controller comprises means for using passive lines of the backplane as a register address but for asserting read or write access to unique registers on switch modules.

In one embodiment, the controller comprises means for transmitting general asynchronous reset commands for all switch modules and for transmitting asynchronous module-specific reset commands in conjunction with the module address on the control bus.

In one embodiment, the backplane is connected to a power supply, and power of different voltage levels is provided on lines of the backplane.

The invention will be more clearly understood from the following description of some embodiments thereof, given by way of example only with reference to the accompanying drawings in which:-
Fig. 1 is a perspective view of a switching system of the invention;
Fig. 2 is a diagrammatic representation of a backplane of the switching system; and
Fig. 3 is a diagrammatic representation of the software architecture of a system controller of the system.

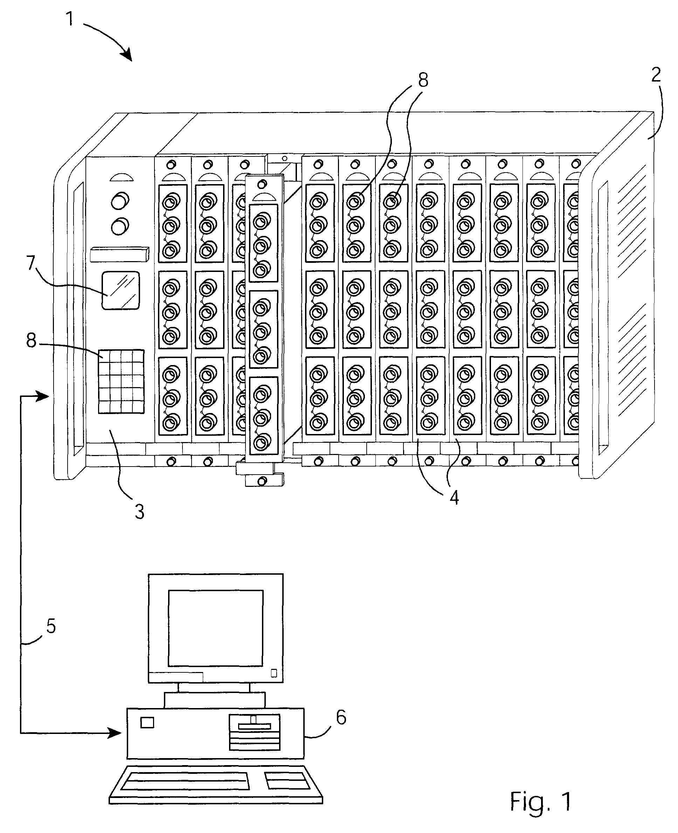

Referring to Fig. 1, the system comprises a chassis 2 having racks supporting a system controller 3 and up to twelve switch modules 4. The system controller 3 and the switch modules 4 are interconnected at the back of the chassis 2 by a backplane, described in more detail below. The system 1 is shown connected to a host system 6 by a General Purpose Interface Bus ("GPIB") at the controller 3. The host interface may alternatively be an RS232 or Ethernet bus, for example.

The controller 3 comprises embedded circuits to perform the following main functions:
host computer interfacing,
MMI (man-machine interface) comprising an LCD display 7, a keypad 8 and associated functionality,
a backplane driver, and
application software including a parser, system housekeeping, error handler, and switch module interrupt handler.

The switch modules 4 comprise general purpose RF or optical switches and the system 1 may include switch modules 4 which perform complex functions such as signal attenuation, measurement, or digital I/O.

The system 1 is for automated test or data acquisition applications with signal routing between instruments. The controller 3 allows dynamic reconfiguration of signals via a backplane on the basis that each switch module 4 automatically "knows" its address by sensing its location in the chassis 2. The controller 3 routes signals according to this address, as described in more detail below. The backplane uses an asynchronous 8/16 bit bus transfer protocol.

The controller 3 picks up simple command strings from the host system 6 via the GPIB bus 5, interprets them, and opens or closes switches on the switch modules 4. A 40 MHz clock provides clock signals to both a GPIB chip and the microprocessor, and a 48 MHz clock is provided for a USB chip. An FPGA has the following functions.
- 1: Generate Chip Selects for the registers and buffers, backplane buffer, front panel, I²C Out, parallel port out, LED out, and Switch in.
- 2: Generate BE8 signal (8 bit access) when PROM, RAM,FLASH are selected
- 3: EEPROM Interface.
- 4: Interrupt routing from front panel (if required).
- 5: Single bit output to watchdog

The controller also includes an EEPROM storing configuration data for FLASH memory, and data in an EPROM is used in default if the EEPROM is empty.

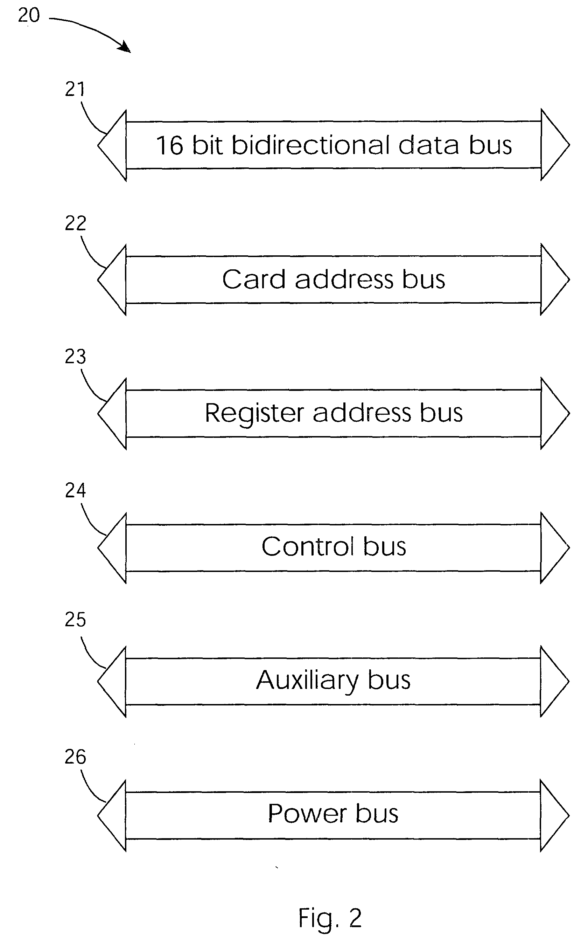

Communications with the switch modules 4 is via the backplane 20, shown in schematic format in Fig. 2. The backplane 20 comprises a connector for each switch module 4 and one for the controller. The controller 3 and the switch modules 4 are simply push-fitted into the connectors as guided by the chassis 2. The backplane 20 is made from double sided FR4, 1.6mm PCB, flammability rated at V0. The outline dimensions are 426.9mm x 129.7mm. The backplane board is finished in green solder mask and has Hot Air Leveled finish on all pads and PTH. There is white silkscreen on the front of the board. The connectors are of type DIN41612 Connector Socket Form A-C, 96 way, with oils rows A and C (A1-A32, C1-C32) used. Two Load 120 Ohm 6W resistors are used on the plus and minus 12Volt power supply lines to ensure that the minimum load is applied to the power supply. 11 x 220 Ohm 4W Wire wound resistors are used on the +5 Volt line to ensure that the minimum power supply load is maintained. The power supply is mounted in the chassis 2. All load resistors are raised from the board using ceramic beads to prevent heat damage to the PCB surface. 11 x 1uF Capacitors are used for de-coupling. One six pin vertical pin connector is used to allow connection to the plus and minus 12Volt supply is via a push on socket. Two screw terminals are included for the +5 Volt supply connection.

The backplane circuit board is laid out in a way such that all of the connectors are facing forward. All other components are mounted on the rear of the backplane board. When mounted in the chassis 2, provision is made for the controller 3 to be inserted in the left-most position. All switch modules 4 are mounted to the right of the controller slot, beginning with slot 1 and ending with slot 12.

At the connectors, four of the pins (A15-A18) are not used by the controller 3 for signalling. Instead, on the backplane 20 they are connected to the ground or are floating (not connected, N/C) on an individual basis at each connector. The combination of GND and N/C for the four pins A15-A18 in each connector provides a 4-bit slot address S0-S3. When a switch module 4 is inserted into a slot in the chassis, it automatically reads the signals on these four pins to determine the address. The S0 to S3 addresses are as set out in Table 1 below.

**Table 1**

| **Slot Number** | **S0** | **S1** | **S2** | **S3** |
|---|---|---|---|---|
| 1 | **N/C** | GND | GND | GND |
| 2 | GND | **N/C** | GND | GND |
| 3 | **N/C** | **N/C** | GND | GND |
| 4 | GND | GND | **N/C** | GND |
| 5 | **N/C** | GND | **N/C** | GND |
| 6 | GND | **N/C** | **N/C** | GND |
| 7 | **N/C** | **N/C** | **N/C** | GND |
| 8 | GND | GND | GND | **N/C** |
| 9 | **N/C** | GND | GND | **N/C** |
| 10 | GND | **N/C** | GND | **N/C** |
| 11 | **N/C** | **N/C** | GND | **N/C** |
| 12 | GND | GND | **N/C** | **N/C** |

The S0-S3 address is hard-coded, being set by physical connections for the pins A15-A18 on an individual basis in each connector. Indeed, the full backplane 20 is passive, and it delivers control signals only when such signals are put onto the remaining pins A1-A14, A19-A32, and C1-C32. The following Table 2 set out the configuration.

**Table 2**

| **Slot Reference DIN41612** | **Cont. (Slot - 0)** | **Switch Modules (Slots 1-12)** | **Slot Reference DIN41612** | **Controller (Slot - 0)** | **Switch Module (Slots 1-12)** |
|---|---|---|---|---|---|
| A1 | GND | 0 Volts | C1 | GND | 0 Volts |
| A2 | VCC | +5 Volts | C2 | VCC | +5 Volts |
| A3 | Chassis GND | Chassis GND | C3 | Future 1 | Future 1 |
| A4 | Chassis GND | Chassis GND | C4 | Future 2 | Future 2 |
| A5 | +12 Volts | +12 Volts | C5 | +12 Volts | +12 Volts |
| A6 | +12 Volts | +12 Volts | C6 | +12 Volts | +12 Volts |
| A7 | Future 4 | Future 4 | C7 | R8 | R9 |
| A8 | Future 5 | Future 5 | C8 | R9 | R10 |
| A9 | -12 Volts | -12 Volts | C9 | R10 | R11 |
| A10 | -12 Volts | -12 Volts | C10 | /CARD ID | /CARD ID |
| A11 | I²C | I²C | C11 | R/W | R/W |
| A12 | I²C | I²C | C12 | CLEAR | CLEAR |
| A13 | IACK | IACK | C13 | RESET | RESET |
| A14 | IRQ | IRQ | C14 | /STROBE | /STROBE |
| A15 | N/C | S3 | C15 | CS3 | CS3 |
| A16 | N/C | S2 | C16 | CS2 | CS2 |
| A17 | N/C | S1 | C17 | CS1 | CS1 |
| A18 | N/C | S0 | C18 | CS0 | CS0 |
| A19 | R7 | R7 | C19 | R3 | R3 |
| A20 | R6 | R6 | C20 | R2 | R2 |
| A21 | R5 | R5 | C21 | R1 | R1 |
| A22 | R4 | R4 | C22 | R0 | R0 |
| A23 | D15 | D15 | C23 | D7 | D7 |
| A24 | D14 | D14 | C24 | D6 | D6 |
| A25 | D13 | D13 | C25 | D5 | D5 |
| A26 | D12 | D12 | C26 | D4 | D4 |
| A27 | D11 | D11 | C27 | D3 | D3 |
| A28 | D10 | D10 | C28 | D2 | D2 |
| A29 | D9 | D9 | C29 | D1 | D1 |
| A30 | D8 | D8 | C30 | D0 | D0 |
| A31 | VCC | +5 Volts | C31 | VCC | +5 Volts |
| A32 | GND | 0 Volts | C32 | GND | 0 Volts |

Referring again to Fig. 2, the backplane 20 comprises the following buses.
21: A 16-bit bi-directional data bus terminating in pins A23-A30 and C23-C30.
22: Card address bus for transmitting CS0 -CS3 as detected by the switch modules 4, described above. This terminates in pins C15-C18. The switch modules 4 derive a card enable signal from this bus.
23: Register address bus to access unique read or write registers on the addressed card, terminating in pins A19-A22, C7-C9, and C19-C22. The address bus provides up to 2048 addresses per system card (2K words/4K bytes). Paged or I/O decoding is provided on each card as necessary.
24: A control bus for:
   Asynchronous reset control, decoded by all switch modules 4. This terminates with pin C13.
   Asynchronous slot-specific reset commands in conjunction with the card address bus 22 to reset a particular module 4. This terminates in pin C13 and the address pins C15-C18.
   Data strobe. Data written by the controller is valid on the falling edge and data is read by the controller on the falling edge during a read cycle.
   A read/write line terminating at pin A11. This is asserted by the controller 3 to signify a read or write cycle. Read cycles are signified by a logic high, and write cycles by a logic low.
   IRQ, namely an interrupt line terminating at pin A14. This is monitored by the controller 3 and asserted by one or more modules 4 requiring service. IRQ is unasserted by the interrupting module during an interrupt acknowledge sequence. IRQ is connected in a wire-Or configuration to all slots.
   IACK (Interrupt Acknowledge), using pin A13, asserted by the controller to indicate an IRQ acknowledge sequence. When IACK is active, the addressed module 4 returns to an IRQ status bit.
   An auxiliary control signal for module identification, appearing at pin C10 and using the module address bus. When this line is active the currently addressed module returns a status byte on the data bus. The status bus identifies the module type and revision. Module ID may also be used in conjunction with the module register address lines to access an additional non-volatile memory area containing manufacturing and calibration information.
24: Auxiliary bus of lines reserved for future use, at pins A7, A8, A11, and A12.
25: A power supply bus providing 5V, 12V, and -12V at pins A5, A6, A9, A10, A31, C5, C6, and C31.

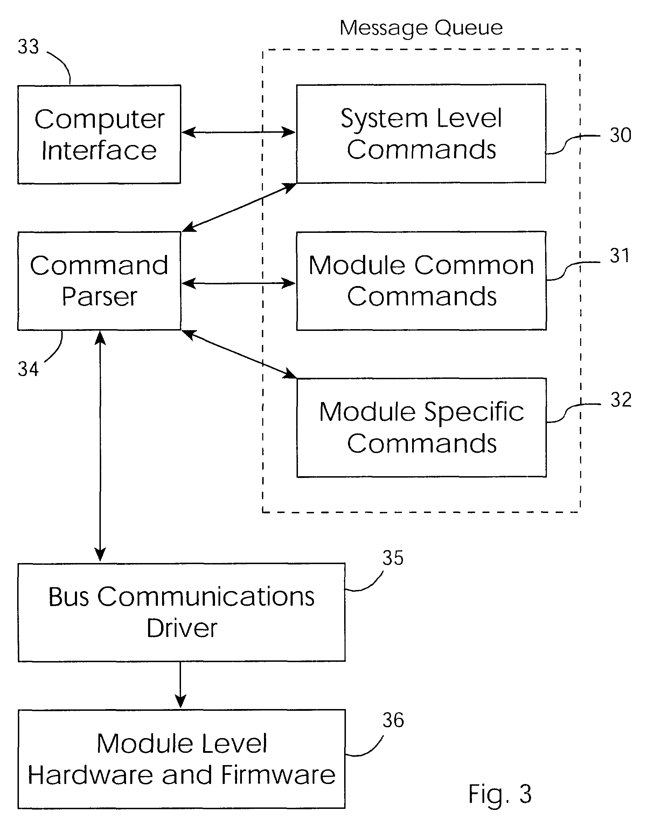

Referring now to Fig. 3, the control architecture of the controller 3 is illustrated. The various system level commands 30, module level commands 31, and module specific commands 32 are as described above. A computer interface 33 is used for software queries of input/output messages from input/output interface handlers including one or more interfaces including GPIB, MMI, serial, USB, and Ethernet. A command parser 34 receives all commands 30, 31, and 32 and decodes and executes them. Examples of system level commands are *RST for resetting the system and IDN? for return of system ID string. Examples of module-common commands are CLR to reset a module and ID? to return a module ID. Examples of module-specific commands are CL to close a module relay and WR to write a digital value to a module.

The bus communication driver 35 comprises layered proprietary calls which perform the following basic bus I/O activities. Data is passed to and from the main message queue based parser executive:
Layer 1 - Card Write, Card Read, Backplane Reset, Card Reset.
Layer 2 - Card Identify, Interrupt Service/Acknowledge

The final block is the module-level hardware and firmware 36 comprising decode logic, data buffering, local power up reset, and optionally, execution engine and memory.

It will be appreciated from the above that the system 1 allows excellent versatility. Switch modules may be connected in any slot because they automatically recognise their address. The control module thus simply places the address on the bus and only the relevant switch module will recognise the address and read the control commands. The switch module configuration is automatically maintained in the controller 3 by each switch module 4 using the bus to inform the controller 3 of its resources correlated to the CS0-CS3 address.

The invention is not limited to the embodiments described, but may be varied in construction and detail within the scope of the claims.

## Claims

1. A switching system comprising a chassis (2), a controller (3), and a plurality of switch modules (4) inserted in racks of the chassis (2), **characterised in that**,
the system comprises a passive backplane (20) comprising a push-fit connector for connection of each switch module (4) to the controller, means in the controller for using passive lines of the backplane as an address bus (32) for addressing switch modules (4), for using passive lines of the backplane as a control bus (24) for transmitting control signals to switch modules, and for using passive lines of the backplane as a data bus (21) for communication of data with switch modules (4), and
the controller comprises a computer interface (5) for interfacing of the system with a host system (6).

2. A switching system as claimed in claim 1, wherein the backplane (20) comprises means for individually applying in a permanent manner a voltage to each pin of a set of pins in each switch module connector, each switch module (4) comprises means for detecting said voltage levels and converting them to a unique address associated with the slot in which the switch module (4) is currently inserted, and the controller (3) comprises means for addressing switch modules (4) on the address bus using said addresses.

3. A switching system as claimed in claim 2, wherein a voltage is applied to each of a set of four pins in each switch module connector.

4. A switching system as claimed in claims 2 or 3, wherein the voltage is either floating or ground, and each switch module comprises means for associating one bit level to floating and another bit level to ground.

5. A switching system as claimed in any of claims 2 to 4, wherein each switch module comprises means for informing the control module of its switch resources, correlated to the current address.

6. A switching system as claimed in claim 5, wherein the controller comprises means for placing a module identification flag on the control bus together with a switch module address on the address bus to poll return of status data identifying the switch module and its revision.

7. A switching system as claimed in and preceding claim, wherein each switch module comprises means for asserting a controller interrupt request on the control bus.

8. A switching system as claimed in any preceding claim, wherein the controller (3) comprises means for using passive lines of the backplane as a register address but for asserting read or write access to unique registers on switch modules (4).

9. A switching system as claimed in any preceding claim, wherein the controller (3) comprises means for transmitting general asynchronous reset commands for all switch modules and for transmitting asynchronous module-specific reset commands in conjunction with the module address on the control bus (24).

10. A switching system as claimed in any preceding claim, wherein the backplane is connected to a power supply, and power of different voltage levels is provided on lines of the backplane.
